(19) 

**Europäisches Patentamt**
**European Patent Office**
**Office européen des brevets**

(11) **EP 2 998 382 A1**

(12) **EUROPEAN PATENT APPLICATION**

(43) Date of publication:
**23.03.2016 Bulletin 2016/12**

(51) Int Cl.:
***C09K 11/64*** *(2006.01)*

(21) Application number: **15182687.2**

(22) Date of filing: **27.08.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **18.09.2014 JP 2014190416**

(71) Applicant: **Kabushiki Kaisha Toshiba**
**Tokyo 105-8001 (JP)**

(72) Inventors:
• **Fukuda, Yumi**
  **Tokyo (JP)**
• **Kato, Masahiro**
  **Tokyo (JP)**

(74) Representative: **Hoffmann Eitle**
**Patent- und Rechtsanwälte PartmbB**
**Arabellastraße 30**
**81925 München (DE)**

(54) **PHOSPHOR, METHOD FOR PRODUCING THE SAME, AND LIGHT-EMITTING DEVICE USING THE SAME**

(57) A present embodiment is to provide a phosphor that has favorable temperature characteristics, that can emit yellow light having excellent color rendering properties, and that has high quantum efficiency. The phosphor emits yellow light when excited with light having a luminescence peak in a wavelength range of 250 to 500 nm and has a crystal structure that is substantially identical to the crystal structure of $Sr_2Al_3Si_7ON_{13}$. In the average crystal structure of the phosphor determined by Rietveld analysis, the distance between an atom at coordinates corresponding to the first coordinates of Sr, M, or Ce atoms and an atom at coordinates corresponding to the 14th coordinates of O or N atoms is 2.0 to 2.6 Å in a case in which the crystal structure is analyzed, assuming that the crystal structure belongs to a space group Pna21, and is represented using crystal structure data standardization software STRUCTURE TIDY.

FIG. 2

EP 2 998 382 A1

**Description**

BACKGROUND

Field of the Invention

An embodiment of the present invention relates to a phosphor, a light-emitting device, and a method for producing the phosphor.

Description of the Related Art

A white light-emitting device comprises a combination of, for example, a phosphor that emits red light by excitation with blue light, a phosphor that emits green light by excitation with blue light, and a blue LED. In contrast, use of a phosphor that emits yellow light by excitation with blue light enables a white light-emitting device to be formed with fewer kinds of phosphors. As such a phosphor that emits yellow light by excitation with blue light, for example, a Eu-activated orthosilicate phosphor is known.

Various applications of such yellow phosphors have been examined, and demands for, e.g., temperature characteristics, quantum efficiency, and color rendering properties in yellow light-emitting phosphors have been increased.

BRIEF DESCRIPTION OF THE DRAWINGS

FIGS. 1A to 1C are views illustrating the crystal structure of $Sr_2Al_3Si_7ON_{13}$;
FIG. 2 is a schematic view illustrating the configuration of a light-emitting device according to an embodiment;
FIG. 3 is a schematic view illustrating the configuration of a light-emitting device according to another embodiment;
FIG. 4 is a view showing the emission spectra of the phosphors of Examples 1 to 4 and Comparative Example 1;
FIG. 5 shows the X-ray diffraction spectrum of the phosphor of Example 1;
FIG. 6 shows the X-ray diffraction spectrum of the phosphor of Example 2;
FIG. 7 shows the X-ray diffraction spectrum of the phosphor of Example 3;
FIG. 8 shows the X-ray diffraction spectrum of the phosphor of Example 4;
FIG. 9 shows the X-ray diffraction spectrum of the phosphor of Comparative Example 1;
FIG. 10 is a flowchart showing a procedure for determining the distances between a Sr atom and the like and an O atom and the like;
FIG. 11 is a view illustrating the positions of atoms in the crystal of Example 1; and
FIG. 12 is a view showing the relationship between a luminous efficiency and an atomic distance.

DETAILED DESCRIPTION

A phosphor according to an embodiment of the present invention exhibits a luminescence peak in a wavelength range of 500 to 600 nm when excited with light having a luminescence peak within a wavelength range of 250 to 500 nm, wherein said phosphor is represented by the following formula (1):

$$((Sr_pM_{1-p})_{1-x}Ce_x)_{2y}Al_zSi_{10-z}O_uN_w \quad (1)$$

wherein M is at least one of alkali metals or alkaline earth metals; and

$$0 \leq p \leq 1,$$

$$0 < x \leq 1,$$

$$0.8 \leq y \leq 1.1,$$

$$2 \leq z \leq 3.5,$$

$$0 < u \leq 1,$$

$$1.8 \leq z - u,$$

and

$$13 \leq u + w \leq 15$$

are satisfied; and

a distance between an atom at a first site of Sr, M, or Ce atoms and an atom at a 14th site of O or N atoms is 2.0 to 2.6 Å in a case in which an average crystal structure of the phosphor is analyzed, assuming that said crystal structure belongs to a space group Pna21, and is represented using crystal structure data standardization software STRUCTURE TIDY.

Embodiments will now be explained with reference to the accompanying drawings.

A phosphor according to an embodiment exhibits a luminescence peak in a wavelength range of 500 to 600 nm when excited with light having a luminescence peak within a wavelength range of 250 to 500 nm, and is therefore a phosphor that can emit light in the region from yellow-green to orange. The phosphor mainly emits light in the yellow region. Therefore, hereinafter, the phosphor according to the present embodiment may be referred to as a yellow light-emitting phosphor.

Such a phosphor comprises a host material having a crystal structure that is substantially identical to the crystal structure of $Sr_2Al_3Si_7ON_{13}$, and the host material is activated with a luminescence center element such as Ce. The composition of the yellow light-emitting phosphor according to the present embodiment is represented by the following general formula (1):

$$((Sr_pM_{1-p})_{1-x}Ce_x)_{2y}Al_zSi_{10-z}O_uN_w \quad (1)$$

wherein M is at least one of alkali metals or alkaline earth metals selected from the group consisting of Ba, Sr, Ca, Mg, Li, Na, and K; and

$$0 \leq p \leq 1, \text{ preferably } 0.85 \leq p \leq 1,$$

$$0 < x \leq 1, \text{ preferably } 0.001 \leq x \leq 0.5,$$

$$0.8 \leq y \leq 1.1, \text{ preferably } 0.85 \leq y \leq 1.06,$$

$$2.0 \leq z \leq 3.5, \text{ preferably } 2.2 \leq z \leq 3.0,$$

$$0 < u \leq 1, \text{ preferably } 0.001 \leq u \leq 0.8,$$

$$1.8 \leq z - u, \text{ preferably } 1.9 \leq z - u,$$

and

## $13 \leq u + w \leq 15$, preferably $13.2 \leq u + w \leq 14.2$

are satisfied.

As shown in the formula (1) described above, some of metal elements forming a host crystal are substituted by a luminescence center element Ce. M is at least one of alkali metals or alkaline earth metals, preferably at least one selected from the group consisting of Ba, Sr, Ca, Mg, Li, Na, and K, more preferably at least one selected from Ba, Ca, and Mg. There may be a case in which p of 1 is desirable for optimizing the luminescence properties of the phosphor. However, even in such a case, there is a case in which metals other than Sr and Ce are contained as unavoidable impurities. In general, in such a case, the effects of the present embodiment are sufficiently exhibited. Ce functions as a luminescence center element. In addition to Ce, an element selected from the group consisting of Tb, Eu, and Mn can be used together as a luminescence center element.

A case in which Ce is 0.1 mol% or more of the total of Sr, M, and Ce can result in sufficient luminous efficiency. It is unnecessary to contain Sr and M (x = 1); however, when x is less than 0.5, reduction in luminous efficiency (concentration quenching) can be suppressed as much as possible. Accordingly, x is preferably 0.001 or more and 0.5 or less. The containing of the luminescence center element Ce allows the phosphor according to the present embodiment to emit light in the yellow region, i.e., to emit light having a peak in a wavelength range of 500 to 600 nm when excited with light having a peak in a wavelength range of 250 to 500 nm. Desired properties are not impaired even when some of Ce is substituted by another metal element like unavoidable impurities. Examples of such unavoidable impurities include Tb, Eu, Mn, and the like. Specifically, the percentage of the unavoidable impurities to the total of Ce and the unavoidable impurities is preferably 15 mol% or less, more preferably 10 mol% or less.

In order to reduce crystal defects to prevent efficiency from decreasing, y is allowed to be 0.8 or more, preferably 0.85 or more. In contrast, for preventing luminous efficiency from decreasing due to the precipitation of an excessive alkaline earth metal as a heterogenous phase, y of 1.1 or less is needed, and it is preferable that y is 1.06 or less. Accordingly, $0.8 \leq y \leq 1.1$ is needed, and $0.85 \leq y \leq 1.06$ is preferable.

For preventing luminescence properties from deteriorating due to the precipitation of excessive Si as a heterogenous phase, z of 2 or more is needed, and z of 2.2 or more is preferable. In contrast, for preventing luminescence properties from deteriorating due to the precipitation of excessive Al as a heterogenous phase in z of more than 3.5, z of 3.5 or less is needed, and z of 3.0 or less is preferable. Accordingly, $2.0 \leq z \leq 3.5$ is needed, and $2.2 \leq z \leq 3.0$ is preferable.

For inhibiting luminous efficiency from deteriorating due to increase in crystal defects, u of 1 or less is needed, and u of 0.8 or less is preferable. In contrast, in order to maintain a desired crystal structure and to appropriately maintain the wavelength of an emission spectrum, u is preferably allowed to be 0.001 or more. Accordingly, $u \leq 1$ is needed, and $0.001 \leq u \leq 0.8$ is preferable.

In order to maintain a desired crystal structure in the phosphor according to the embodiment and to inhibiting a heterogenous phase from being generated when the phosphor is produced, a value of z - u of 1.8 or more is needed, and a value of z - u of 1.9 or more is preferable. For the same reason, $13 \leq u + w \leq 15$ is needed, and $13.2 \leq u + w \leq 14.2$ is preferable.

The phosphor according to the present embodiment includes all of the preferred conditions mentioned above and is therefore capable of emitting yellow light excellent in color rendering properties with a high degree of efficiency when excited with light having a luminescence peak in a wavelength range of 250 to 500 nm. Moreover, the yellow light-emitting phosphor according to the present embodiment has features of high efficiency, a wide light-emitting half-width, and favorable temperature characteristics because of also having the features of the crystal structure mentioned later.

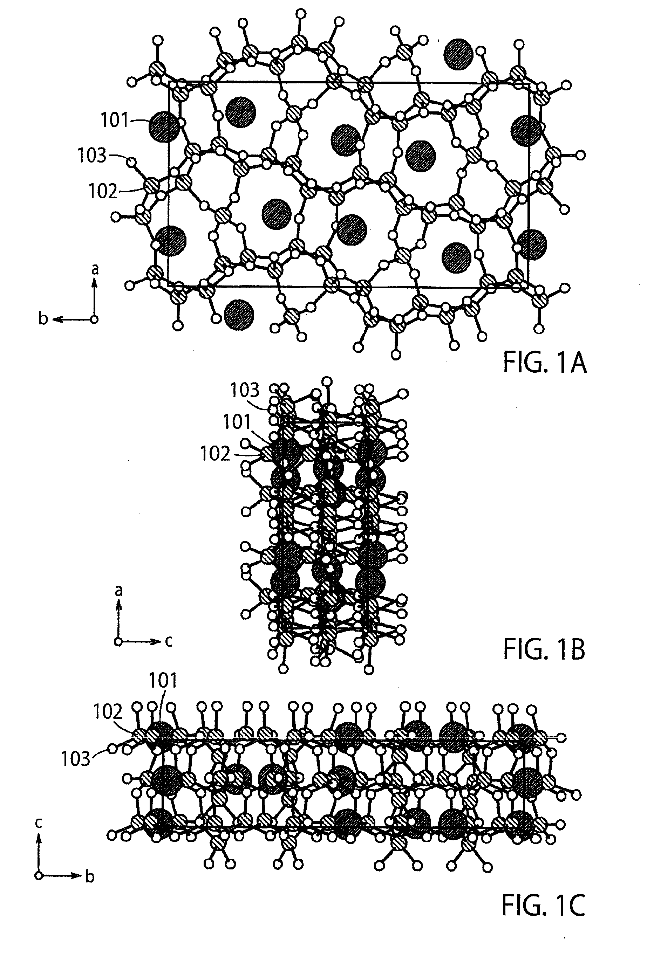

The yellow light-emitting phosphor according to the embodiment of the present invention is based on an inorganic compound having a crystal structure that is substantially identical to the crystal structure of $Sr_2Al_3Si_7ON_{13}$, in which some of elements Sr forming the compound are substituted by luminescence center ions Ce. The crystal structure of $Sr_2Al_3Si_7ON_{13}$ is as illustrated in FIG. 1. In FIG. 1, an atom 101 is a Sr atom or a Ce atom, an atom 102 is a Si atom or an Al atom, and an atom 103 is an O atom or a N atom. It may be considered that the phosphor is based on $Sr_2Al_3Si_7ON_{13}$, in which Si and Al are replaced with each other, or O and N are replaced with each other, and another metal element such as Ce forms a solid solution. In the present embodiment, such a crystal is referred to as a $Sr_2Al_3Si_7ON_{13}$-based crystal. Such replacement of an atom or the like may result in slight change of a crystal structure but rarely results in change of an atom position to such a large extent that a chemical bond between skeleton atoms is cleaved. The atom position is determined by the crystal structure, the site occupied by the atom, and its coordinate. The $Sr_2Al_3Si_7ON_{13}$ crystal belongs to a monoclinic system, particularly to an orthorhombic system, with lattice constants of a = 11.7 Å, b = 21.4 Å, and c = 4.96 Å. The crystal belongs to the space group Pna21.

The yellow light-emitting phosphor according to the present embodiment has a characteristic crystal structure. In a $Sr_2Al_3Si_7ON_{13}$-based crystal, one Sr atom is bound to plural O or N atoms. The plural O or N atoms are positioned around the one Sr atom to surround the Sr atom. The relative positions of the atoms in the general $Sr_2Al_3Si_7ON_{13}$-based

crystal generally correspond to those in a fundamental $Sr_2Al_3Si_7ON_{13}$ crystal. In the present embodiment, the O or N atoms positioned to surround the Sr atom are considered to be bound to the Sr atom.

However, only the position of one Sr atom bound to O or N atoms with respect to the positions of the O or N atoms bound to the one Sr atom in the phosphor according to the present embodiment is different from that in the basic crystal structure. As a result, the distance between one certain atom of plural O or N atoms and a Sr atom in the phosphor according to the present embodiment is markedly shorter than the distance between a corresponding certain Sr atom and a certain O or N atom in the above-mentioned fundamental $Sr_2Al_3Si_7ON_{13}$ crystal.

A bond distance in such a crystal structure can be calculated by single-crystal XRD diffraction or Rietveld analysis of powder data. The Rietveld analysis is an analysis method of calculating, e.g., the lattice constants or atomic coordinate positions of a crystal on the basis of powder XRD diffraction data or powder neutron diffraction data. In general, a single crystal is often used for analyzing a crystal structure. However, a powder sample is used in the Rietveld analysis. When a powder sample is used, it is commonly difficult to separate diffraction peaks because the diffraction peaks complicatedly overlap each other. However, in the Rietveld analysis, a crystal structure is precisely determined by first setting a reference crystal structure and by performing analysis. The reference crystal structure is set based on a standard crystal structure. In the present embodiment, the reference crystal structure is set based on a typical $Sr_2Al_3Si_7ON_{13}$ crystal. The average crystal structure of a sample is determined by allowing it to include, e.g., a difference from the reference crystal structure based on, e.g., the powder XRD diffraction data of the sample. The average crystal structure of the sample is the average value of the crystal structure included in the sample and is quite different from the reference crystal structure. Specific techniques for such Rietveld analysis are also described in various literatures. In the present embodiment, the techniques can be used. Rietveld analysis can be easily performed using analysis software contained in various X-ray diffractometers.

In the above, the distance between the Sr atom and the O or N atom is described. In the phosphor according to the present embodiment, however, distances including the distances between Ce atoms and O or N atoms as well as the distances between M atoms and the O or N atoms are calculated in the calculation of the average value of the distances because some of Sr atoms are substituted by Ce or M atoms.

In the phosphor according to the present embodiment, the distance between a certain Sr, M, or Ce atom and a certain O or N atom in the average crystal structure calculated in such a manner is 2.0 to 2.6 Å, preferably 2.3 to 2.58 Å. The certain Sr, M, or Ce atom is an atom at the first site of Sr, M, or Ce atoms in a case in which the crystal structure of the phosphor is analyzed, assuming that the crystal structure belongs to a space group Pna21, and is represented using crystal structure data standardization software STRUCTURE TIDY. Similarly, the certain O or N atom is an atom at the 14th site of O or N atoms in a case in which the crystal structure of the phosphor is analyzed, assuming that the crystal structure belonging to a space group Pna21, and is represented using crystal structure data standardization software STRUCTURE TIDY.

When the distance between the certain Sr, M, or Ce atom as described above and the certain O or N atom is less than 2.0 Å, the crystal structure is not maintained, the crystal does not become a $Sr_2Si_7Al_3ON_{13}$-based crystal, and therefore, it is impossible to maintain excellent light-emitting performance.

The yellow light-emitting phosphor according to the present embodiment can be produced by an arbitrary method. Specifically, the phosphor according to the embodiment of the present invention can be produced by mixing raw material powders containing each element and by firing the mixture. In this case, it is preferable to use specific raw materials and to control firing atmosphere.

A Sr-containing raw material can be selected from nitrides, silicides, carbides, carbonates, hydroxides, and oxides of Sr. A M-containing raw material can be selected from nitrides, silicides, carbides, carbonates, hydroxides, and oxides of M. An Al-containing raw material can be selected from nitrides, oxides, and carbides of Al, and a Si-containing raw material can be selected from nitrides, oxides, and carbides of Si. A Ce-containing raw material can be selected from chlorides, oxides, nitrides, and carbonates of Ce.

Nitrogen can be given from a nitride raw material or from atmosphere containing nitrogen by firing in the atmosphere, and oxygen can be given from an oxide raw material or from a surface oxidation coating of a nitride raw material.

For example, $Sr_3N_2$, AlN, $Si_3N_4$, $Al_2O_3$ and AlN, and $CeCl_3$ are mixed in preparation composition which may form composition of interest. $Sr_2N$, SrN, $SrSi_2$, or the like, or a mixture thereof may be used instead of $Sr_3N_2$. For obtaining a uniform mixed powder, it is desirable to perform dry mixing of the raw material powders in order of increasing mass.

The raw materials can be mixed, for example, using a mortar in a glove box. The mixed powders are encased in a crucible and fired under predetermined conditions, to thereby obtain the phosphor according to the present embodiment. The material of the crucible is not particularly limited but can be selected from boron nitride, silicon nitride, silicon carbide, carbon, aluminum nitride, sialon, aluminum oxide, molybdenum, tungsten, and the like.

It is desirable to fire the mixed powders at a pressure that is not less than atmospheric pressure. The firing at the pressure that is not less than atmospheric pressure is advantageous in view of inhibiting silicon nitride from decomposing. For suppressing the decomposition of silicon nitride at high temperature, a pressure (absolute pressure) of 5 atmospheres or more is more preferred, and a firing temperature ranging from 1500 to 2000°C is preferable. Such conditions allow a sintered body of interest to be obtained without causing trouble such as sublimation of a material or a product. When there are a plurality of firing steps as mentioned below, it is preferable to perform some or all of the firing steps under a pressurization condition. A firing temperature of 1800 to 2000°C is more preferred.

In the present embodiment, it is preferable to control a temperature condition in the case of cooling after the firing. In general, a fired product is allowed to stand to cool in a heating furnace when a phosphor is produced by firing. The rate of reduction in its temperature is around 10°C/min. In the present embodiment, the rate of reduction in its temperature is preferably less than 10°C/min, more preferably 5°C/min or less, particularly preferably 3°C/min or less. It is only required to perform such temperature control before atmosphere is cooled to a temperature of around 1300°C. The cooling rate is referred to as the rate of cooling the atmosphere rather than the rate of cooling the fired product itself.

The firing atmosphere preferably has a low oxygen content in every firing step. This is because oxidation of raw materials such as AlN is avoided. Specifically, firing in nitrogen atmosphere, high-pressure nitrogen atmosphere, or deoxidation atmosphere is desired. The atmosphere may contain up to around 50 vol% of hydrogen molecules.

It is preferable to perform firing at the above-described temperature for 0.5 to 10 hours, to then take a fired product out of the crucible to crush the fired product, and to re-fire the crushed product under the same conditions. A series of such steps of taking-out, crushing, and firing is repeated around 0 to 10 times, thereby resulting in advantages that the fusion of crystal grains hardly occurs and that it is easy to generate a powder with a uniform composition and crystal structure.

After the firing, as needed, post-treatment such as cleaning is performed to obtain a phosphor according to an embodiment. For example, pure water, an acid, or the like can be used in the cleaning. Examples of the acid that can be used include inorganic acids such as sulfuric acid, nitric acid, hydrochloric acid, and hydrofluoric acid; organic acids such as formic acid, acetic acid, and oxalic acid; mixed acids thereof; and the like.

Before or after acid cleaning, post-annealing treatment may be performed as needed. The order of the post-annealing treatment and the acid cleaning can be appropriately changed depending on an objective. The post-annealing treatment can be performed, for example, in reducing atmosphere containing nitrogen and hydrogen. Crystallinity and luminous efficiency are improved by such post-annealing treatment.

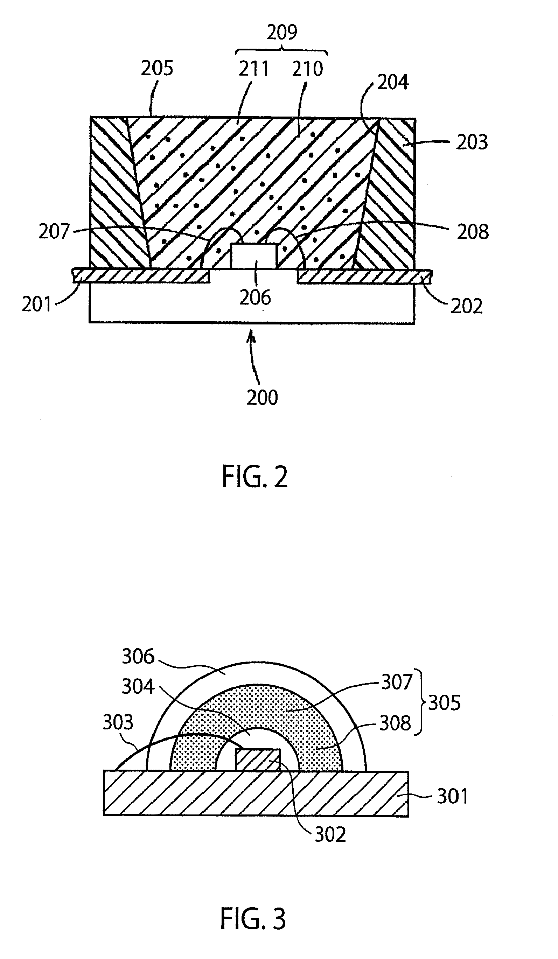

A light-emitting device according to an embodiment comprises: a fluorescence light-emitting layer containing the above-described phosphor; and a light-emitting element for exciting the above-described phosphor. FIG. 2 is a schematic view illustrating the configuration of the light-emitting device according to the embodiment.

In the light-emitting device illustrated in FIG. 2, leads 201 and 202, and a package cup 203 are placed on a substrate 200. The substrate 200 and the package cup 203 are resinous. The package cup 203 has a recess 205 of which the top is larger than the bottom. The side of the recess functions as a reflecting surface 204.

A light-emitting element 206 is mounted, with an Ag paste or the like, on the center of the generally circular bottom surface of the recess 205. The light-emitting element 206 used emits light having a luminescence peak in a wavelength range of 400 to 500 nm. Examples of the light-emitting element 206 include a light-emitting diode, a laser diode, and the like. Specific examples of the light-emitting element 206 include, but are not limited to, semiconductor light-emitting elements such as GaN-based semiconductor light-emitting elements; and the like.

The p-electrode and n-electrode (not illustrated) of the light-emitting element 206 are connected, through bonding wires 207 and 208 comprising Au or the like, to the lead 201 and the lead 202, respectively. The arrangement of the leads 201 and 202 can be appropriately changed.

As the light-emitting element 206, a flip-chip-type light-emitting element including an n-type electrode and a p-type electrode on the same surface can also be used. In such a case, problems caused by a wire, such as the disconnection and peeling of the wire, and the absorption of light into the wire, are solved to provide a semiconductor light-emitting device with high reliability and high luminance. The following structure can also be made using a light-emitting element comprising an n-type substrate. An n-electrode is formed on the back surface of the n-type substrate of the light-emitting element, and a p-electrode is formed on the top surface of a p-type semiconductor layer layered on the substrate. The n-electrode is mounted on a lead, and the p-electrode is connected to the other lead through a wire.

A fluorescence light-emitting layer 209 containing a phosphor 210 according to an embodiment is placed in the recess 205 of the package cup 203. In the fluorescence light-emitting layer 209, the phosphor 210 in an amount of 5 to 60 mass% is contained, for example, in a resin layer 211 comprising silicone resin. As described above, the phosphor according to the present embodiment contains $Sr_2Al_3Si_7ON_{13}$ as a base material, and such an oxynitride has high covalency. Therefore, the phosphor according to the present embodiment is hydrophobic and has excellent compatibility with resins. Accordingly, scattering on the interface between the resin layer and the phosphor is markedly suppressed to improve light extraction efficiency.

The yellow light-emitting phosphor according to the present embodiment has favorable temperature characteristics and can emit yellow light excellent in color rendering properties with high efficiency. A white light-emitting device having excellent luminescence properties is provided by combining the yellow light-emitting phosphor with a light-emitting element that emits light having a luminescence peak in a wavelength range of 400 to 500 nm.

The size and kind of the light-emitting element 206 as well as the dimension and shape of the recess 205 can be appropriately changed.

The light-emitting device according to the embodiment is not limited to such package-cup-type light-emitting devices as illustrated in FIG. 2 but can be appropriately changed. Specifically, the phosphor of the embodiment can also be applied to a bullet-type LED or a surface-mount-type LED, to obtain a similar effect.

FIG. 3 illustrates a schematic view illustrating the configuration of a light-emitting device according to another embodiment. In the light-emitting device illustrated in the figure, a p-electrode and an n-electrode (not illustrated) are formed in a predetermined region in an insulating substrate 301 with heat radiation characteristics, and a light-emitting element 302 is placed thereon. The material of the insulating substrate with heat radiation characteristics may be, for example, AIN.

One electrode in the light-emitting element 302 is disposed on the bottom surface of the light-emitting element 302 and is electrically connected to the n-electrode of the insulating substrate 301 with heat radiation characteristics. The other electrode in the light-emitting element 302 is connected, through a gold wire 303, to the p-electrode (not illustrated) on the insulating substrate 301 with heat radiation characteristics. As the light-emitting element 302, a light-emitting diode that emits light having a luminescence peak in a wavelength range of 400 to 500 nm is used.

An internal transparent resin layer 304 having a dome shape, a fluorescence light-emitting layer 305, and an external transparent resin layer 306 are sequentially formed on the light-emitting element 302. The internal transparent resin layer 304 and the external transparent resin layer 306 can be form with, for example, silicone or the like. In the fluorescence light-emitting layer 305, for example, a yellow light-emitting phosphor 307 of the present embodiment is contained in a resin layer 308 comprising silicone resin.

In the light-emitting device illustrated in FIG. 3, the fluorescence light-emitting layer 305 comprising the yellow light-emitting phosphor according to the present embodiment can be easily produced by adopting a technique such as vacuum printing or drop-coating from a dispenser. Moreover, since such a fluorescence light-emitting layer 305 is positioned by the internal transparent resin layer 304 and the external transparent resin layer 306, an effect of improving the extraction efficiency is obtained.

The fluorescence light-emitting layer of the light-emitting device according to the present embodiment may contain a green light-emitting phosphor that emits green light by excitation with blue light and a red light-emitting phosphor that emits red light by excitation with blue light as well as the yellow light-emitting phosphor of the present embodiment. In such a case, a white light-emitting device superior in color rendering properties is provided.

Yellow light is also emitted when the yellow light-emitting phosphor according to the present embodiment is excited with light in an ultraviolet region of 250 to 400 nm. Accordingly, a white light-emitting device can also be formed by combining the phosphor according to the present embodiment with, for example, a blue light-emitting phosphor that emits blue light by excitation with ultraviolet light and a light-emitting element such as an ultraviolet light-emitting diode. A fluorescence light-emitting layer in such a white light-emitting device may contain a phosphor that emits light having a peak in another wavelength range by excitation with ultraviolet light, as well as the yellow light-emitting phosphor of the present embodiment. Examples of the phosphor include a phosphor that emits red light by excitation with ultraviolet light, a phosphor that emits green light by excitation with ultraviolet light, and the like.

As described above, the phosphor of the present embodiment has favorable temperature characteristics and can emit yellow light excellent in color rendering properties with high efficiency. A white light-emitting device having excellent luminescence properties can be provided using a few kinds of phosphors by combining such a yellow light-emitting phosphor of the present embodiment with a light-emitting element that emits light having a luminescence peak in a wavelength range of 250 to 500 nm.

EXAMPLES

Specific examples of the phosphor and light-emitting device according to the embodiments of the present invention are described as follows.

[Example 1]

As raw materials, $Sr_3N_2$, $CeCl_3$, $Si_3N_4$, and AIN were prepared and each weighed. The masses of blended $Sr_3N_2$, $CeCl_3$, $Si_3N_4$, and AIN were 2.963 g, 0.222 g, 5.402 g, and 1.414 g, respectively. The blended raw material powders were dry-mixed using a planetary ball mill in a glove box under nitrogen atmosphere.

The resulting mixture was encased in a boron nitride (BN) crucible, was retained in nitrogen atmosphere at a pressure of 7.5 atmospheres at 1700°C for 1 hour, was cooled to 1300°C at a cooling rate of 2°C/min while controlling its temperature, and was then furnace-cooled. The fired product was taken out of the crucible and was crushed in an agate mortar. The fired product that had been crushed was re-encased in the crucible, was retained at 1850°C for 4 hours, was cooled to 1300°C at a cooling rate of 2°C/min while controlling its temperature, and was then furnace-cooled.

A series of such steps of taking-out, crushing, and firing was repeatedly performed twice, to thereby obtain a phosphor of Example 1.

The obtained phosphor, which was a powder with a yellow body color, was confirmed to emit yellow light when excited with black light.

[Example 2]

As raw materials, $SrSi_2$, $CeCl_3$, $Si_3N_4$, and AlN were prepared and each weighed. The masses of blended $SrSi_2$, $CeCl_3$, $Si_3N_4$, and AlN were 4.416 g, 0.185 g, 3.085 g, and 1.414 g, respectively. The blended raw material powders were dry-mixed using a planetary ball mill in a glove box under nitrogen atmosphere.

The resulting mixture was encased in a boron nitride (BN) crucible, was retained in nitrogen atmosphere at a pressure of 7.5 atmospheres at 1700°C for 1 hour, was cooled to 1300°C at a cooling rate of 2°C/min while controlling its temperature, and was then furnace-cooled. The fired product was taken out of the crucible and was crushed in an agate mortar. The fired product that had been crushed was re-encased in the crucible, was retained at 1850°C for 4 hours, was cooled to 1300°C at a cooling rate of 2°C/min while controlling its temperature, and was then furnace-cooled. A series of such steps of taking-out, crushing, and firing was repeatedly performed twice, to thereby obtain a phosphor of Example 2.

The obtained phosphor, which was a powder with a yellow body color, was confirmed to emit yellow light when excited with black light.

[Example 3]

As raw materials, $SrSi_2$, $CeCl_3$, $Si_3N_4$, and AlN were prepared and each weighed. The masses of blended $SrSi_2$, $CeCl_3$, $Si_3N_4$, and AlN were 4.416 g, 0.185 g, 3.085 g, and 1.414 g, respectively. The blended raw material powders were dry-mixed using a planetary ball mill in a glove box under nitrogen atmosphere.

The resulting mixture was encased in a boron nitride (BN) crucible, was retained in nitrogen atmosphere at a pressure of 7.5 atmospheres at 1850°C for 10 hours, was cooled to 1300°C at a cooling rate of 5°C/min while controlling its temperature, and was then furnace-cooled. The fired product was taken out of the crucible and was crushed in an agate mortar. The fired product that had been crushed was re-encased in the crucible, was retained at 1850°C for 10 hours, was cooled to 1300°C at a cooling rate of 5°C/min while controlling its temperature, and was then furnace-cooled. A series of such steps of taking-out, crushing, and firing was repeatedly performed twice, to thereby obtain a phosphor of Example 3.

The obtained phosphor, which was a powder with a yellow body color, was confirmed to emit yellow light when excited with black light.

[Example 4]

As raw materials, $SrSi_2$, $CeCl_3$, and $Si_3N_4$ were prepared to first synthesize an intermediate product. The masses of blended $SrSi_2$, $CeCl_3$, and $Si_3N_4$ were 4.206 g, 0.185 g, and 0.856 g, respectively. The blended raw material powders were dry-mixed using a planetary ball mill in a glove box under nitrogen atmosphere.

The resulting mixture was encased in a boron nitride (BN) crucible, and was fired in hydrogen/nitrogen atmosphere at a pressure of one atmosphere at 1500°C for 4 hours. The fired product was taken out of the crucible and was crushed in an agate mortar. The fired product that had been crushed was re-encased in the crucible, and was fired at 1500°C for 4 hours in the same manner, to obtain the intermediate product.

The weighing of each of 2.152 g of the intermediate product, 0.631 g of $Si_3N_4$, and 0.471 g of AlN was performed, and they were dry-blended using the planetary ball mill.

The resulting mixture was encased in a boron nitride (BN) crucible, was retained in nitrogen atmosphere at a pressure of 7.5 atmospheres at 1850°C for 10 hours, was cooled to 1300°C at a cooling rate of 5°C/min while controlling its temperature, and was then furnace-cooled. The fired product was taken out of the crucible and was crushed in an agate mortar. The fired product that had been crushed was re-encased in the crucible, was retained at 1850°C for 10 hours, was cooled to 1300°C at a cooling rate of 5°C/min while controlling its temperature, and was then furnace-cooled. A series of such steps of taking-out, crushing, and firing was repeatedly performed twice, to thereby obtain a phosphor of Example 4.

The obtained phosphor, which was a powder with a yellow body color, was confirmed to emit yellow light when excited with black light.

[Comparative Example 1]

As raw materials, $Sr_3N_2$, $CeO_2$, $Si_3N_4$, $Al_2O_3$, and AlN were prepared and each weighed. The masses of blended $Sr_3N_2$, $CeO_2$, $Si_3N_4$, $Al_2O_3$, and AlN were 2.851 g, 0.103 g, 4.911 g, and 1.467 g, respectively. The blended raw material powders were dry-mixed using a planetary ball mill in a glove box under nitrogen atmosphere.

The resulting mixture was encased in a boron nitride (BN) crucible, was retained in nitrogen atmosphere at a pressure of 7.5 atmospheres at 1700°C for 1 hour, was cooled to 1300°C at a cooling rate of 10°C/min while controlling its temperature, and was then furnace-cooled. The fired product was taken out of the crucible and was crushed in an agate mortar. The fired product that had been crushed was re-encased in the crucible, was retained at 1850°C for 4 hours, was cooled to 1300°C at a cooling rate of 10°C/min while controlling its temperature, and was then furnace-cooled. A series of such steps of taking-out, crushing, and firing was repeatedly performed twice, to thereby obtain a phosphor of Comparative Example.

The obtained phosphor, which was a powder with a yellow body color, was confirmed to emit yellow light when excited with black light.

Evaluation of Composition

The compositions of the resulting phosphors of Examples 1 to 4 and Comparative Example 1 were analyzed as listed in Table 1.

Table 1

|  | Sr | Ce | Al | Si | O | N |
|---|---|---|---|---|---|---|
| Example 1 | 7.29 | 0.25 | 8.92 | 29.4 | 1.3 | 53 |
| Example 2 | 7.38 | 0.20 | 8.95 | 29.6 | 1.1 | 52 |
| Example 3 | 7.20 | 0.21 | 9.06 | 29.4 | 1.5 | 52 |
| Example 4 | 7.39 | 0.24 | 9.55 | 29.6 | 1.2 | 52 |
| Comparative Example 1 | 7.21 | 0.24 | 12.70 | 26.6 | 3.8 | 49 |
| Unit: mol concentration (%) | | | | | | |

Evaluation of Luminescence Properties

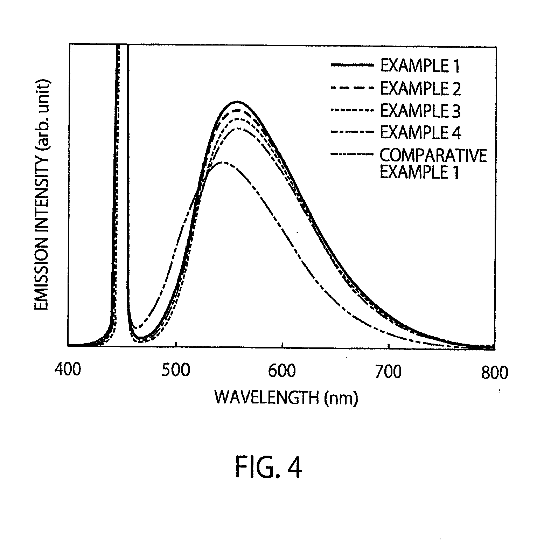

FIG. 4 shows the emission spectra of the phosphors excited with light having an emission wavelength of 450 nm dispersed from a xenon lamp. In FIG. 4, emitted light having a narrow half-width at around 450 nm is not light emitted from the phosphors but reflected excitation light. All of the phosphors of Examples 1 to 4 were confirmed to show high emission intensities with peak wavelengths of 554 to 559 nm. It was observed that each of the phosphors of Examples 1 to 4 showed the emission intensity that was higher than that of the phosphor of Comparative Example 1. The half-widths determined by using an instantaneous multichannel spectrometer were 119 to 121 nm. A half-width is one of the indices of the color rendering properties of white light emitted from a light-emitting device. Commonly, a wider half-width easily results in white light having higher color rendering properties. It is shown that white light having excellent color rendering properties is easily provided by using the phosphors according the embodiments because of their half-widths of 119 to 121 nm. The absorptances, internal quantum efficiencies, and external quantum efficiencies in the case of the excitation at 450 nm, provided from the emission spectra in the case of the excitation at 450 nm shown in FIG. 4, are listed in Table 2.

Table 2

|  | Absorptance | Internal quantum efficiency | External quantum efficiency |
|---|---|---|---|
| Example 1 | 0.795 | 0.894 | 0.711 |
| Example 2 | 0.829 | 0.832 | 0.690 |
| Example 3 | 0.860 | 0.823 | 0.708 |
| Example 4 | 0.785 | 0.828 | 0.650 |
| Comparative Example 1 | 0.638 | 0.807 | 0.515 |

Powder X-ray Diffraction and Rietveld Analysis Thereof

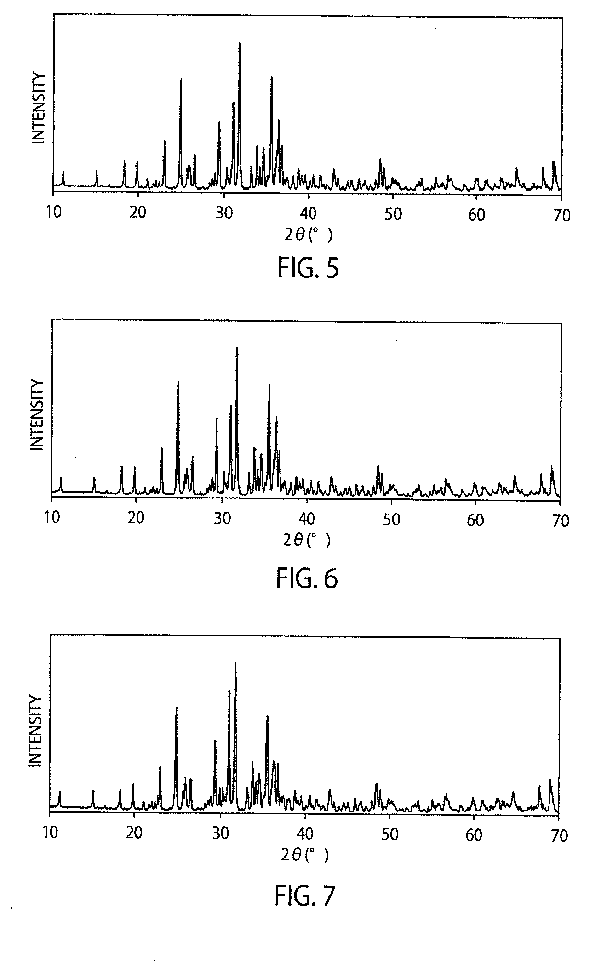

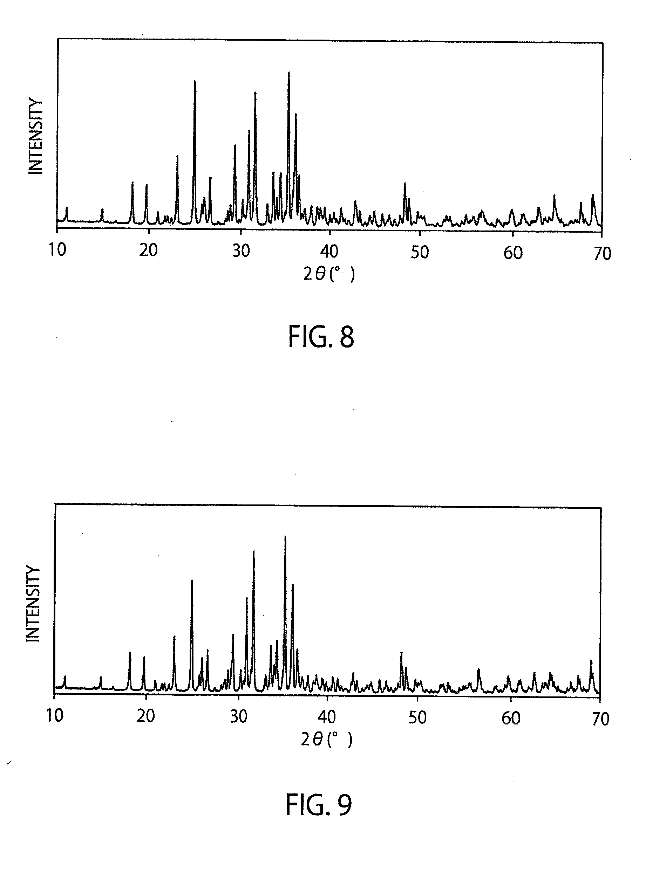

A diffracting device with a monochromator (Rint2100 (trade name), manufactured by Rigaku Corporation) using a K$\alpha$ line of copper as a radiation source was used for measuring an X-ray diffraction spectrum. Before the measurement, an automatic setting attached to the device was performed for correcting the positions of an X-ray source and a diffraction system and for correcting the slight displacement of a goniometer, followed by measuring the X-ray diffraction profile of standard silicon (Si), to confirm the achievement of the corrections. The measurement range of a diffraction spectrum was set at 10° to 120° at 2$\theta$, a step-size at 0.01°, and measurement time at 1 second per step. These conditions are standard in Rietveld structure analysis. The powder X-ray diffraction spectra of Examples 1 to 4 and Comparative Example are shown in FIGS. 5 to 9.

For the structure analysis of Examples and Comparative Example, only integrated powder X-ray analysis software PDXL2 (manufactured by Rigaku Corporation) was used as a Rietveld structure analysis program. Prior to the analysis, reference crystal structure data listed in Table 3 was used as the initial value data of the crystal structures. In the reference crystal structure, the a-axis length was set at 11.6767 Å, the b-axis length at 21.3910 Å, and the c-axis length at 4.9620 Å. Its space group was Pna21.

Table 3 shows fractional coordinates showing sites that are one-fourth those of an entire unit lattice. In other words, assuming that the fractional coordinates in Table 3 belong to a space group Pna21, the coordinates of each element of the unit lattice can be determined by development (hereinafter referred to as development) according to symmetry of the space group.

The distance between a certain Sr, M, or Ce atom and a certain O or N atom can be determined using the developed coordinates of the unit lattice. The certain Sr, M, or Ce atom is an atom at a site obtained by developing the atom at the first site of Sr, M, or Ce atoms and the fractional coordinates according to the first site (i.e., an atom at the equivalent position of the fractional coordinates) in a case in which the crystal structure of a phosphor is analyzed, assuming that the crystal structure belongs to a space group Pna21, and is represented using crystal structure data standardization software STRUCTURE TIDY. The coordinates of the atom are regarded as "coordinates corresponding to the first coordinates".

Similarly, the certain 0 or N atom is an atom at a site obtained similarly by developing the atom at 14th site of O or N atoms and the fractional coordinates according to the 14th site (i.e., an atom at the equivalent position of the fractional coordinates) in a case in which the crystal structure of a phosphor is analyzed, assuming that the crystal structure belongs to a space group Pna21, and is represented using crystal structure data standardization software STRUCTURE TIDY. The coordinates of the atom are regarded as "coordinates corresponding to the 14th coordinates".

The distance between the certain Sr, M, or Ce atom and the certain O or N atom can be determined from a combination of the sites of atoms determined in such a manner.

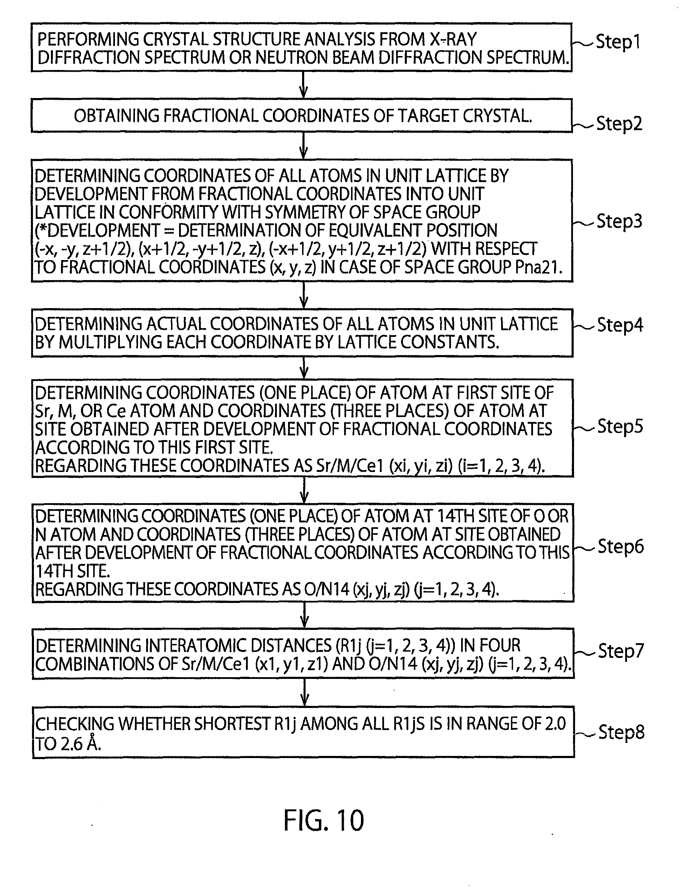

A specific example of the procedure is shown in FIG. 10.

Table 3

| Element | Site | x | y | z |
|---|---|---|---|---|
| Sr/M/Ce1 | 4a | 0.27857(6) | 0.49070(3) | 0.31162(19) |
| Sr/M/Ce2 | 4a | 0.35525(6) | 0.69834(3) | 0.7914(3) |
| Si/Al1 | 4a | 0.35788(16) | 0.27697(9) | 0.7909(7) |
| Si/Al2 | 4a | 0.07865(16) | 0.70029(8) | 0.7915(7) |
| Si/Al3 | 4a | 0.19194(16) | 0.63952(8) | 0.3041(7) |
| Si/Al4 | 4a | 0.00358(16) | 0.54352(8) | 0.2927(7) |
| Si/Al5 | 4a | 0.55677(16) | 0.46692(8) | 0.2985(7) |
| Si/Al6 | 4a | 0.39467(17) | 0.34711(9) | 0.2903(7) |
| Si/Al7 | 4a | 0.16173(16) | 0.56553(8) | -0.1922(7) |
| Si/Al8 | 4a | 0.47243(16) | 0.60941(8) | 0.2992(8) |
| Si/Al9 | 4a | 0.1546(3) | 0.34817(13) | 0.5289(6) |
| Si/Al10 | 4a | 0.1553(3) | 0.34966(14) | 0.0231(6) |
| O/N1 | 4a | 0.0664(5) | 0.3167(3) | 0.280(2) |
| O/N2 | 4a | 0.2530(5) | 0.3749(3) | 0.283(2) |

(continued)

| Element | Site | x | y | z |
|---------|------|-----------|-----------|------------|
| O/N3 | 4a | 0.2131(5) | 0.2983(3) | 0.773(2) |
| O/N4 | 4a | 0.1015(5) | 0.3996(3) | -0.235(2) |
| O/N5 | 4a | 0.4050(6) | 0.2731(3) | 0.4571(16) |
| O/N6 | 4a | 0.3621(6) | 0.2067(3) | 0.9695(17) |
| O/N7 | 4a | 0.4919(6) | 0.3985(3) | 0.4519(17) |
| O/N8 | 4a | 0.4389(6) | 0.3335(3) | 0.9582(16) |
| O/N9 | 4a | 0.3356(5) | 0.6342(3) | 0.3472(15) |
| O/N10 | 4a | 0.0545(6) | 0.5193(3) | -0.0253(17) |
| O/N11 | 4a | 0.1600(6) | 0.6423(3) | -0.0419(16) |
| O/N12 | 4a | 0.1259(6) | 0.5734(3) | 0.4586(17) |
| O/N13 | 4a | 0.4887(6) | 0.5338(3) | 0.4528(17) |
| O/N14 | 4a | 0.7036(5) | 0.4688(3) | 0.331(2) |

The a-axis length of the average crystal structure of Example 1, obtained from the X-ray diffraction spectrum of FIG. 5 by Rietveld analysis was 11.6984 Å, the b-axis length thereof was 21.3494 Å, and the c-axis length thereof was 4.9545 Å. The atomic coordinates thereof are listed in Table 4.

Table 4

| Element | Site | x | y | z |
|----------|------|--------|--------|---------|
| Sr/M/Ce1 | 4a | 0.2803 | 0.4912 | 0.3259 |
| Sr/M/Ce2 | 4a | 0.3537 | 0.6982 | 0.8080 |
| Si/Al1 | 4a | 0.4768 | 0.6067 | 0.2856 |
| Si/Al2 | 4a | 0.1521 | 0.3514 | 0.5250 |
| Si/Al3 | 4a | 0.1559 | 0.3487 | 0.0184 |
| Si/Al4 | 4a | 0.3643 | 0.2758 | 0.7638 |
| Si/Al5 | 4a | 0.0811 | 0.6981 | 0.7552 |
| Si/Al6 | 4a | 0.1976 | 0.6410 | 0.2937 |
| Si/Al7 | 4a | 0.0022 | 0.5447 | 0.2761 |
| Si/Al8 | 4a | 0.5609 | 0.4659 | 0.3130 |
| Si/Al9 | 4a | 0.3938 | 0.3443 | 0.2919 |
| Si/Al10 | 4a | 0.1669 | 0.5648 | -0.2134 |
| O/N1 | 4a | 0.2085 | 0.2996 | 0.7649 |
| O/N2 | 4a | 0.4014 | 0.2732 | 0.4564 |
| O/N3 | 4a | 0.4292 | 0.3364 | 0.9434 |
| O/N4 | 4a | 0.3751 | 0.2091 | 0.9405 |
| O/N5 | 4a | 0.2538 | 0.3871 | 0.2740 |
| O/N6 | 4a | 0.0761 | 0.3202 | 0.2781 |
| O/N7 | 4a | 0.1038 | 0.3981 | -0.2286 |
| O/N8 | 4a | 0.4972 | 0.3954 | 0.4807 |

(continued)

| Element | Site | x | y | z |
|---------|------|-------|--------|---------|
| O/N9 | 4a | 0.0485 | 0.5183 | -0.0090 |
| O/N10 | 4a | 0.1680 | 0.6389 | -0.0112 |
| O/N11 | 4a | 0.1249 | 0.5732 | 0.4646 |
| O/N12 | 4a | 0.3455 | 0.6371 | 0.3647 |
| O/N13 | 4a | 0.5022 | 0.5339 | 0.4812 |
| O/N14 | 4a | 0.7078 | 0.4718 | 0.3401 |

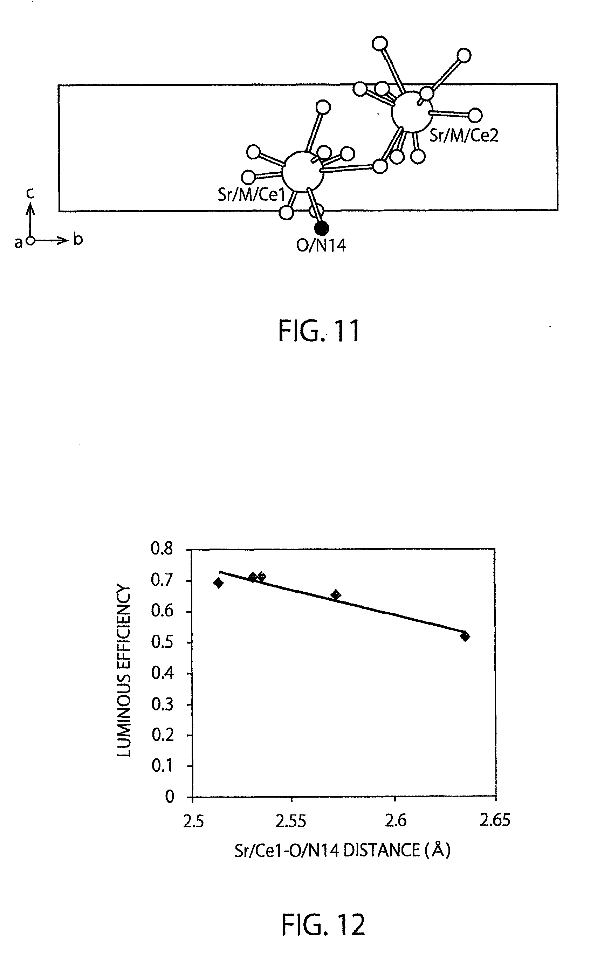

The coordination environment of Sr/M/Ce obtained from the atomic coordinates of Table 4 is illustrated in FIG. 11. FIG. 11 is a drawing of viewing a crystal structure along the a-axis. Because the space group Pna21 of the crystal structure has a two-fold screw axis in the c-axis direction, all of atoms in a unit lattice are arranged so that when the atoms are rotated at 180° about the c-axis and translationally moved for a distance that is one-half the c-axis length in the c-axis direction, the original atoms and the moved atoms overlap each other. N14 denoted by the red circle in FIG. 11 corresponds to a position where O/N14 indicating the atomic coordinates in Table 4 is rotated at 180° about the c-axis and translationally moved for a half distance in the c-axis direction. In FIG. 11, the coordinates of O/N14 close to Sr/M/Ce1 correspond to coordinates obtained by converting the x, y, and z coordinates of O/N14 in Table 4 on the basis of the following expression.

$$(x1, y1, z1) = (-x, -y, z + 1/2) + (1, 1, -1)$$

The distance between the coordinates (x1, y1, z1) of Sr/M/Ce1 and O/N14 can be calculated based on the Pythagorean theorem. The Sr/M/Ce1-to-O/N14 distances of Examples 1 to 4 and Comparative Example are listed in Table 5.

Table 5

| | Sr/M/Ce1-O/N14 |
|---|---|
| Example 1 | 2.54 |
| Example 2 | 2.51 |
| Example 3 | 2.53 |
| Example 4 | 2.57 |
| Comparative Example 1 | 2.64 |

The relationship between the luminous efficiencies and the Sr/M/Ce1-to-O/N14 distances obtained from Table 2 and Table 5 is shown in FIG. 12. FIG. 12 reveals that a Sr/M/Ce1-to-O/N14 distance in a range of 2.0 to 2.6 Å results in high luminous efficiency.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the invention.

**Claims**

1.    A phosphor, exhibiting a luminescence peak in a wavelength range of 500 to 600 nm when excited with light having a luminescence peak within a wavelength range of 250 to 500 nm,
wherein said phosphor is represented by the following formula (1):

$$((Sr_pM_{1-p})_{1-x}Ce_x)_{2y}Al_zSi_{10-z}O_uN_w \quad (1)$$

wherein M is at least one of alkali metals or alkaline earth metals; and

$$0 \leq p \leq 1,$$

$$0 < x \leq 1,$$

$$0.8 \leq y \leq 1.1,$$

$$2.0 \leq z \leq 3.5,$$

$$0 < u \leq 1,$$

$$1.8 \leq z - u,$$

and

$$13 \leq u + w \leq 15$$

are satisfied; and
a distance between an atom at coordinates corresponding to first coordinates of Sr, M, or Ce atoms and an atom at coordinates corresponding to 14th coordinates of O or N atoms is 2.0 to 2.6 Å in a case in which an average crystal structure of said phosphor is analyzed, assuming that the crystal structure belongs to a space group Pna21, and is represented using crystal structure data standardization software STRUCTURE TIDY.

2. The phosphor according to claim 1, wherein M is at least one selected from Ba, Ca, and Mg.

3. The phosphor according to claim 1, wherein said distance is within the range of 2.3 to 2.58 Å.

4. A light-emitting device, comprising:

a light-emitting element that emits light having a luminescence peak in a wavelength range of 250 to 500 nm; and
a fluorescence light-emitting layer containing a yellow light-emitting phosphor that receives light from the light-emitting element and emits yellow light, said yellow light-emitting phosphor being the phosphor according to claim 1.

5. The light-emitting device according to claim 4, wherein said fluorescence light-emitting layer further contains a phosphor that emits green light and a phosphor that emits red light.

6. A light-emitting device, comprising:

a light-emitting element that emits light having a luminescence peak in a wavelength range of 250 to 400 nm; and
a fluorescence light-emitting layer containing a yellow light-emitting phosphor that receives light from the light-emitting element and emits yellow light and a blue light-emitting phosphor that receives light from the light-emitting element and emits blue light, said yellow light-emitting phosphor being the phosphor according to claim 1.

7. A method for producing the phosphor according to claim 1, comprising:

a step of mixing a Sr-containing raw material selected from nitrides, silicides, carbides, carbonates, hydroxides, and oxides of Sr, a M-containing raw material selected from nitrides, carbides, carbonates, hydroxides, and oxides of M, an Al-containing raw material selected from nitrides, oxides, and carbides of Al, a Si-containing raw material selected from nitrides, oxides, and carbides of Si, and a Ce-containing raw material selected from chlorides, oxides, nitrides, and carbonates of Ce, to obtain a mixture; and
a step of firing said mixture.

8. The method according to claim 7, wherein said mixture is fired at 1500 to 2000°C under a pressure of 5 atmospheres or more.

9. The method according to claim 7, wherein said mixture is fired in nitrogen atmosphere.

10. The method according to claim 7, wherein a cooling rate is less than 10°C/min before temperature of atmosphere reaches 1300°C in a case in which a fired product is cooled after the firing.

11. The method according to claim 7, further comprising:

a step of cleaning said fired product after the firing.

FIG. 1A

FIG. 1B

FIG. 1C

FIG. 2

FIG. 3

FIG. 4

FIG. 5

FIG. 6

FIG. 7

FIG. 8

FIG. 9

| PERFORMING CRYSTAL STRUCTURE ANALYSIS FROM X-RAY DIFFRACTION SPECTRUM OR NEUTRON BEAM DIFFRACTION SPECTRUM. | Step1 |
|---|---|

| OBTAINING FRACTIONAL COORDINATES OF TARGET CRYSTAL. | Step2 |
|---|---|

| DETERMINING COORDINATES OF ALL ATOMS IN UNIT LATTICE BY DEVELOPMENT FROM FRACTIONAL COORDINATES INTO UNIT LATTICE IN CONFORMITY WITH SYMMETRY OF SPACE GROUP (*DEVELOPMENT = DETERMINATION OF EQUIVALENT POSITION $(-x, -y, z+1/2)$, $(x+1/2, -y+1/2, z)$, $(-x+1/2, y+1/2, z+1/2)$ WITH RESPECT TO FRACTIONAL COORDINATES $(x, y, z)$ IN CASE OF SPACE GROUP Pna21. | Step3 |
|---|---|

| DETERMINING ACTUAL COORDINATES OF ALL ATOMS IN UNIT LATTICE BY MULTIPLYING EACH COORDINATE BY LATTICE CONSTANTS. | Step4 |
|---|---|

| DETERMINING COORDINATES (ONE PLACE) OF ATOM AT FIRST SITE OF Sr, M, OR Ce ATOM AND COORDINATES (THREE PLACES) OF ATOM AT SITE OBTAINED AFTER DEVELOPMENT OF FRACTIONAL COORDINATES ACCORDING TO THIS FIRST SITE. REGARDING THESE COORDINATES AS Sr/M/Ce1 $(x_i, y_i, z_i)$ $(i=1, 2, 3, 4)$. | Step5 |
|---|---|

| DETERMINING COORDINATES (ONE PLACE) OF ATOM AT 14TH SITE OF O OR N ATOM AND COORDINATES (THREE PLACES) OF ATOM AT SITE OBTAINED AFTER DEVELOPMENT OF FRACTIONAL COORDINATES ACCORDING TO THIS 14TH SITE. REGARDING THESE COORDINATES AS O/N14 $(x_j, y_j, z_j)$ $(j=1, 2, 3, 4)$. | Step6 |
|---|---|

| DETERMINING INTERATOMIC DISTANCES $(R_{1j}$ $(j=1, 2, 3, 4))$ IN FOUR COMBINATIONS OF Sr/M/Ce1 $(x_1, y_1, z_1)$ AND O/N14 $(x_j, y_j, z_j)$ $(j=1, 2, 3, 4)$. | Step7 |
|---|---|

| CHECKING WHETHER SHORTEST $R_{1j}$ AMONG ALL $R_{1j}$S IS IN RANGE OF 2.0 TO 2.6 Å. | Step8 |
|---|---|

FIG. 10

FIG. 11

FIG. 12

Europäisches
Patentamt
European
Patent Office
Office européen
des brevets

**EUROPEAN SEARCH REPORT**

Application Number

EP 15 18 2687

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 597 129 A1 (TOSHIBA KK [JP]) 29 May 2013 (2013-05-29) * paragraphs [0005] - [0028]; claims 1-15 * ----- | 1-11 | INV. C09K11/64 |
| A | US 2006/197439 A1 (SAKANE KENJI [JP] ET AL) 7 September 2006 (2006-09-07) * paragraph [0024]; claims 1-23 * ----- | 1-11 | |
| A | US 2013/234585 A1 (ALBESSARD KEIKO [JP] ET AL) 12 September 2013 (2013-09-12) * claims 1-18; examples 1-9 * ----- | 1-11 | |
| A | EP 2 597 131 A1 (TOSHIBA KK [JP]) 29 May 2013 (2013-05-29) * paragraph [0005] - paragraph [0020]; claims 1-15 * ----- | 1-11 | |

TECHNICAL FIELDS
SEARCHED    (IPC)

C09K

The present search report has been drawn up for all claims

| Place of search | Date of completion of the search | Examiner |
|---|---|---|
| The Hague | 26 January 2016 | Kövecs, Monika |

EPO FORM 1503 03.82 (P04C01)

## ANNEX TO THE EUROPEAN SEARCH REPORT
## ON EUROPEAN PATENT APPLICATION NO.

EP 15 18 2687

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2016

| Patent document cited in search report | | Publication date | Patent family member(s) | | Publication date |
|---|---|---|---|---|---|
| EP 2597129 | A1 | 29-05-2013 | CN | 103113895 A | 22-05-2013 |
| | | | EP | 2597129 A1 | 29-05-2013 |
| | | | JP | 5762929 B2 | 12-08-2015 |
| | | | JP | 2013104041 A | 30-05-2013 |
| | | | KR | 20130054123 A | 24-05-2013 |
| | | | KR | 20140130078 A | 07-11-2014 |
| | | | TW | 201335336 A | 01-09-2013 |
| | | | US | 2013241387 A1 | 19-09-2013 |
| US 2006197439 | A1 | 07-09-2006 | NONE | | |
| US 2013234585 | A1 | 12-09-2013 | JP | 2013119592 A | 17-06-2013 |
| | | | US | 2013234585 A1 | 12-09-2013 |
| EP 2597131 | A1 | 29-05-2013 | CN | 103113883 A | 22-05-2013 |
| | | | EP | 2597131 A1 | 29-05-2013 |
| | | | JP | 2013104040 A | 30-05-2013 |
| | | | KR | 20130054124 A | 24-05-2013 |
| | | | TW | 201326358 A | 01-07-2013 |
| | | | US | 2013229106 A1 | 05-09-2013 |

EPO FORM P0459

For more details about this annex : see Official Journal of the European Patent Office, No. 12/82